# EUROPEAN PATENT APPLICATION

(11) **EP 0 592 975 A2**
(43) Date of publication of application: **20.04.1994**
(21) Application number: 93116403.2
(22) Date of filing: 10.10.1993
(51) Int. Cl.: H04N 5/50, H03J 1/00

(54) **Voltage synthesis tuning method for television signal receivers with direct channel call**

(30) Priority: 14.10.1992 IT TO920828
(71) Applicant: SELECO S.p.A., I-33170 Pordenone (IT)
(72) Inventor: Liverotti, Giorgio, I-33170 Pordenone (IT)
(74) Representative: Dini, Roberto, Dr. Ing.

(57) **Abstract**

The present invention relates to a tuning method for voltage synthesis television signal receivers; the main characteristic of the invention consists in that a plurality of digital codes, each identifying respectively a voltage corresponding to a television channel, are memorised before the sale of the receiver in a tuning memory (15) of the non volatile digital type, to a corresponding plurality of addresses and that for executing the direct call of the desired channel the user types on a command unit (16) the channel number, that said command unit (16) sends to a control unit (14) of the receiver a corresponding signal and that the control unit (14) reads in the memory (15) the corresponding digital code and sends it to the tuning unit (10) that provides for tuning the desired channel.

## Description

The present invention relates to a tuning method for voltage synthesis television signal receivers.

There are known television signal receivers (for example televisions or video recorders) functioning according to the method of voltage synthesis tuning.

For example in English patent N 1 520 849 a tuning method is described in which a plurality of digital codes, are memorised, the first time that the channel is tuned, in a digital tuning memory, to a corresponding plurality of addresses.

At the moment of executing once again the tuning of the same channel, the digital code relative to the desired channel is read from the memory, is converted to an analog value, and the corresponding voltage to such value is applied to the tuner, that is of the normal type having a voltage controlled oscillator (V.C.O).

It is known that voltage synthesis tuning systems are subject to drifting phenomenons, due for example to variations in the temperature, or to the ageing of the components; such phenomenons cause the tuning to no longer be exact (in fact it never is).

For this motive such systems also generally provide a so-called automatic tuning circuit(A.F.C.), for replacing the tuning to an acceptable value.

However all known voltage synthesis tuning systems have the drawback that for storing the digital codes in the memory corresponding to the channels desired to be received in due course it is necessary to initially tune one at a time the desired channels utilising the so-called automatic search method (i.e. a sequential exploration of all the receivable frequencies) and successively memorise them one at a time.

The aim of the present invention is to indicate a tuning method for voltage synthesis television signal receivers, that allows the user, upon the initial turning on of the apparatus, to directly call any channel desired.

For allowing such aims the present invention has as its subject a tuning method for voltage synthesis television signal receivers, characteristic in that a plurality of digital codes, each identifying respectively a voltage corresponding to a television channel, are memorised before the sale of the receiver in a tuning memory of the non volatile digital type, to a corresponding plurality of addresses and that for executing the direct call of the desired channel the user types on a command unit (16) the channel number, that said command unit (16) sends to a control unit (14) of the receiver a corresponding signal and that the control unit reads in the memory the corresponding digital code and sends it to the tuning unit that provides for tuning the desired channel.

It is known that the automatic tuning circuits (AFC) have the necessity of being sized based on a compromise; it is in fact known that the slope, i.e. the precision, of the AFC circuit is inversely proportional to the pull-in range; as a consequence, so as to guarantee an acceptable precision such circuits can not have a very large grasping field; unfortunately the drifting is generally greater than such field.

The English patent N. 1 518 712 proposes to memorise a modified digital code, in place of the original, whenever a discrepancy of tuning is detected greater than a prefixed acceptability limit.

If however a channel is not selected for a long period of time, it may occur that, upon the moment of selection, the drifting results in being greater than the pull-in range and the tuning results in being impossible.

For overcoming this drawback, the cited English patent N. 1 520 849 provides that, upon the operation of tuning, it is detected whether the it is to be found outside the aforementioned pull-in range, and, in such case, a cyclic variation of the digital code is executed, so as to vary the frequency and to bring it within the range, and that the code correction be memorised.

It is clear that all of this requires a complex and delicate apparatus, and problems as a consequence can occur during practice, with the results of dissatisfying the user. A simple and effective method of management of the voltage synthesis system, that guarantees a reliable tuning, will now be described; such method in fact allows for the preliminary memorisation of the tuning codes of all the standard channels in the memory.

Further aims and advantages of the present invention will result in being clear from the following detailed description and annexed drawings, supplied purely as an explanatory and non limiting example, wherein:
figure 1 schematically represents a simplified block diagram of a television signals receiver according to the invention;
figure 2 represents the course of the frequency and of the automatic tuning voltage (AFC) during the search phase of a station, in a tuning system according to the invention;
figure 3 represents the course of the frequency and of the automatic tuning voltage (AFC) during the recall phase of a station previously memorised, in a tuning system according to the invention.

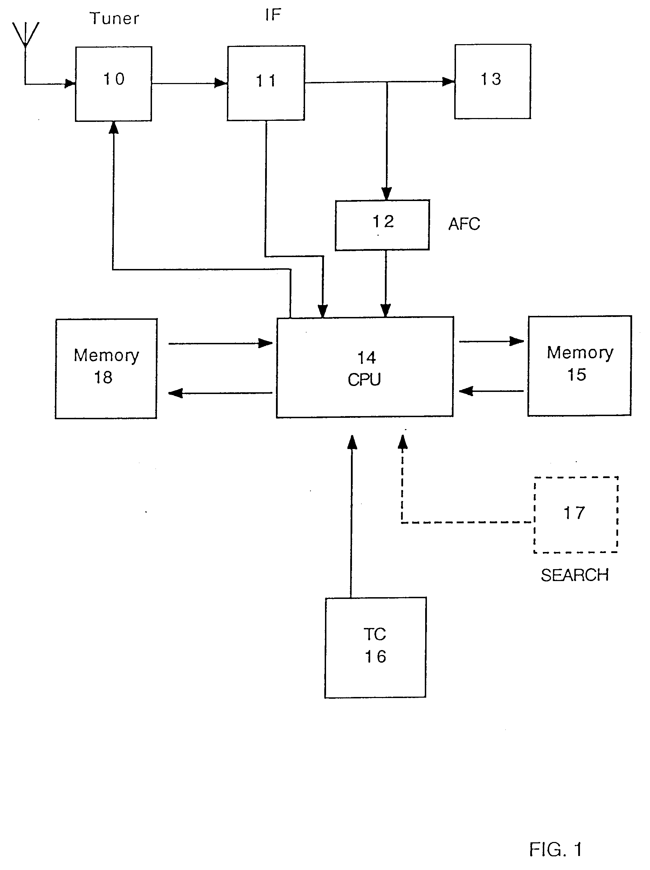

In figure 1 with the reference number 10 the tuner is indicated, of the conventional voltage synthesis type; with reference number 11 the combination (substantially conventional) of the intermediate frequency amplifying circuits and signal demodulators is indicated; with reference number 12 the automatic tuning circuit (AFC) is indicated; with reference number 13 the combination of the remaining circuits of the receiver of television signals is indicated, being of the conventional type.

Still with figure 1, with reference number 14 the central control unit (microprocessor or microcontroller) is indicated; reference number 15 indicates the non volatile type memory, but electrically erasable and re-writable, within which the digital codes are memorised corresponding to the tuning voltages of all the channels that can be received by the receiver of television signals in question.

With reference number 16 a command organ is indicated, for sending command signals to the control unit 14; such command organ can be for example a conventional remote control unit, with the relative receiver.

With reference number 17 an auxiliary command unit is indicated, that can be contained in the receiver, or, for cost reasons, may be available only to the factory and in service stations; such auxiliary command unit serves in sending to the control unit 14 the signals necessary for executing the preliminary search and tuning operation of all the receivable channels, and relative memorising of the relative digital codes in the memory 15.

Finally reference number 18 indicates a second non volatile memory, utilised for memorising preferred channels; such memory can for example contain twenty or more cells; in each cell, by way of the control unit 14, in following an opportune command executed by the user, through the command unit 16, the correspondence between the number of a channel and the number of the key of the remote control with which the channel can be recalled is memorised. As is known such system of indirect recall is that normally utilised with voltage synthesis systems, without the possibility of direct call; such system can be mnemonically useful (association of the channel RAI 1 with the key 1, of the channel RAI 2 with the key 2, and so on).

The voltage synthesis tuning method according to the invention provides that the microcontroller 14 be coupled to a D/A converter with the necessary resolution, for example 14 bits; for tuning the receiver on a determined channel the local oscillator of the tuner 10 has to oscillate to the central frequency of the channel, having increased the intermediate frequency value.

This is obtained by charging the D/A converter of the microcontroller with the appropriate digital tuning code and selecting the band, effecting the relative band commutation lines. The tuning code converted in voltage pilots the voltage controlled oscillator (VCO) of the tuner and on the tuner itself the band commutation lines.

The tuning of a station by the system does not finish as mentioned above, but is completed with a sophisticated control.

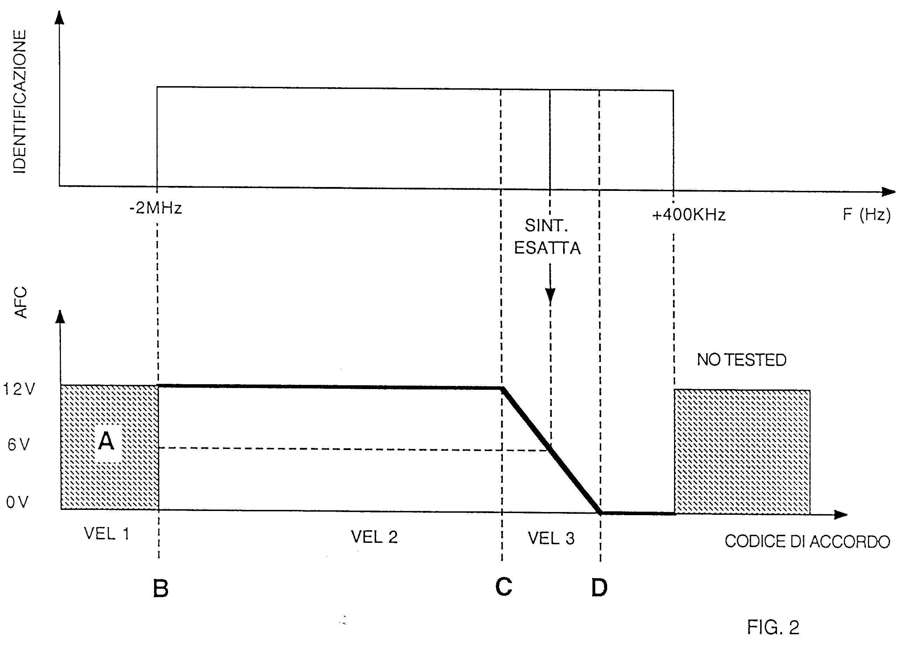

The microcontroller in the preliminary channel search phase (and memorisation of the relative codes) increases the tuning code in such sections as to obtain in output from the voltage controlled oscillator (VCO) of the tuner frequency variations of the order of approximately 500 KHz (speed 1) for each single section (see fig. 2, A); simultaneously the microcontroller tests the identification signal coming from the intermediate frequency integrated circuit 11, with the aim of detecting or not the presence of a station. If the presence of a station is not detected, the microcontroller increases the tuning code a further section (still that producing a frequency variation of approximately 500 KHz) and re-executes the test on the presence of the identification signal coming from the intermediate frequency integrated circuit, with the aim of detecting or not the presence of a station.

These operations are carried out by the microcontroller until the information of the identification signal does not signal the presence of a station.

In the presence of a station the microcontroller modifies the increment of the tuning code so as to obtain a frequency variation of approximately 200 KHz (speed 2) at each section (see fig. 2, B) . From this moment on, at each section, the contemporary presence of the identification signal and of the signal is tested, coming from the A/D converter, able to discriminate the level of the signal coming from the automatic tuning circuit (AFC) 12.

When the microcontroller detects for the first time the descending section (see fig. 2, C) of the automatic tuning curve (AFC), by way of the reading of the converter A/D, it memorises in the memory 15, the value of the effective tuning code in that moment and modifies the increment of the tuning code so as to obtain the slightest variation possible at each section (approximately 50 KHz, speed 3), in order to have the maximum resolution.

From this moment on, at each section, the contemporary presence of the identification signal and of the signal is tested, coming from the A/D, in order to detect the point in which the curve reaches a lower stabilised value (see fig. 2, D). At this point the microcontroller calculates the avarage value between the actual tuning code and that previously memorised and memorises such avarage in the memory 15, to the address corresponding to the selected channel; in this way the system will carry out a tuning of the channel as close as possible to its ideal.

As can be clearly seen in the figure the pull-in range results in being very large, and simultaneously the slope of the AFC device results in being very accentuated; in this way both a large pull-in range (assured by the digital search system) and a high tuning precision (assured by the slope of the AFC) are obtained.

In the channel recall phase the microcontroller has to recall from the memory 15 the previously memorised tuning code, for the D/A converter, the information relative to the band and, eventually, a code relative to the transmission standard, in the case of a multistandard receiver.

However the tuning of a station by the microcontroller does not finish with what has been mentioned above; in fact it is completed by sophisticated control operations.

Due to the tuning drifts caused by temperature variations (be it either environmental or that within the receiver itself), the tuning of the relative station may require variations of the voltage tuning (and therefore of digital codes) being more or less large.

For overcoming this the microcontroller 14 executes corrections on the previously memorised tuning code, as will now be described; it is however to be noted that, in such phase, the corrected tuning code is not memorised.

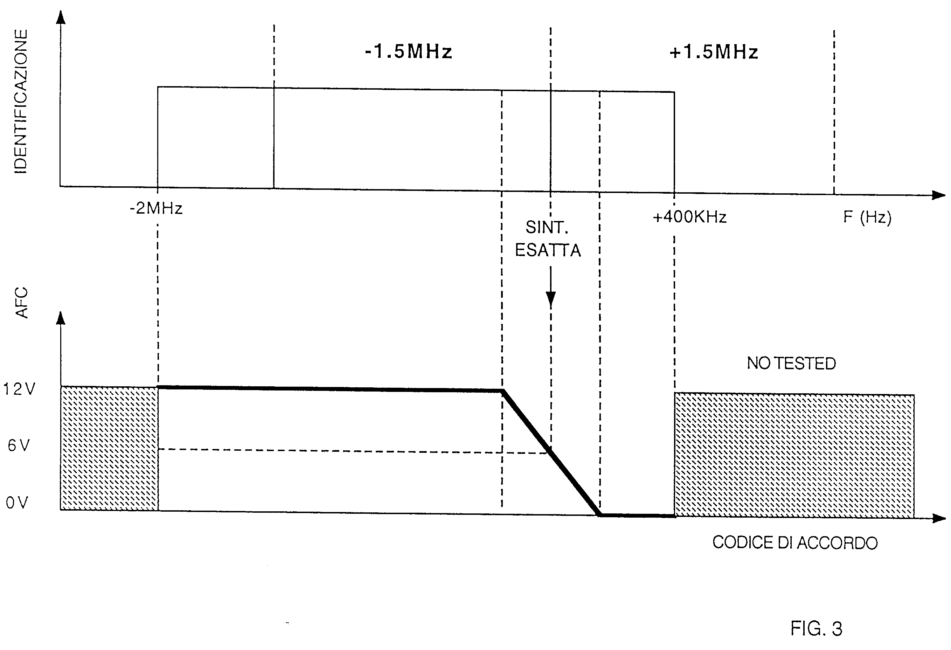

It is stated that the maximum frequency drift has been detected as more or less 1,5 MHz. At each station change the microcontroller, after having charged the tuning data relative to the newly selected station, it tests the presence of the identification signal coming from the integrated circuit of intermediate frequency, with the aims of detecting the presence or not of a station. If the presence of a station is not detected, the microcontroller knows that the drifting has been verified in a negative sense (in fact if the drifting occurs in a positive sense the station results in being present, due to the characteristics of the television signal) and that it is necessary to decrease the agreement frequency respect the actual one (see fig. 3).

The microcontroller therefore decreases the tuning code by one section (equal to 500 KHz in frequency) and re-executes the test on the identification signal; in the negative case the decrease and successive test are repeated up to a maximum of four times (for a total of approximately 2 MHz), unless the presence of a station is not detected before.

In the presence of a station the microcontroller 14 modifies the variation section of the tuning code in order to obtain a frequency variation of approximately 200 KHz per section. At each section the presence of the identification code and of the signal coming from the A/D converter is tested, indicative of the level of voltage coming from the automatic tuning circuit 12.

Analysing the information received from the A/D converter the microcontroller 14 is able to establish as to whether the current tuning code brings about a positive or negative mistuning (see fig. 3; in the illustrated case the exact tuning corresponds to 6 volt output from the AFC circuit) . As a consequence, in the vicinity of a correct tuning, the microcontroller 14 modifies the tuning code so as to obtain a frequency variation of approximately 50 KHz in the opposite sense of the mistuning; with successive sections the system is thus brought back to a correct tuning, eliminating the drifting effect.

In this phase it is assumed that the correct tuning is that corresponding to a 6 volt signal in output from the automatic tuning.

Moreover, the microcontroller 14 also provides for the correction of the drifting of a minor entity, slower in time (for example that due to an eventual antenna converter). In fact the microcontroller, even during its normal functioning as a receiver, tests the identification signal, coming from the integrated circuit of intermediate frequency 11, for detecting the presence of a station; if the presence of a station is not detected, no correction is carried out; in the presence of a station the microcontroller 14 tests the signal coming from the A/D converter, indicative of the level of voltage coming from the automatic tuning circuit 12; if the microcontroller detects a mistuning, be it negative or positive, it provides for modifying the tuning code as a consequence, in order to obtain a variation of 50 Khz in the opposite sense of the detected mistuning.

This constant control over time means that the slow mistunings become eliminated, allowing an always optimum vision and a perfect decoding of an eventual teletext transmission, which as known is very sensitive to perfect tuning.

On the other hand also this control during normal functioning the eventual correct tuning code is not memorised in the digital tuning memory.

The characteristics of the voltage synthesis tuning method described result in being clear from the description of the example.

From the executed description the advantages of the method subject of the present invention are also clear.

In particular they consist in that:
- the method consents the user the direct call of any channel desired even upon turning on the appliance for the first time;
- the method assures a very large pull-in range, and contemporaneously a high tuning precision;
- the perfect drifting correction is guaranteed, in any moment of the reception;
- drifts of approximately 2 MHz are recaptured upon the act of calling a station; in this way, even after a long dormant period, the tuning is guaranteed;
- a service of a practically perfect tuning is obtained, with simple means; in fact a microcontroller is already present in almost all modern receivers; the additional circuits required are of a limited number and of modest cost.

It is clear that the method described is more efficient and being more simple, and therefore more reliable than those already known; it is also clear that numerous variants are possible by the skilled man, to the method described as an example, without for this departing from the novelty principles inherent in the invention.

## Claims

1. Tuning method for voltage synthesis television signal receivers, characterised in that a plurality of digital codes, each identifying respectively a voltage corresponding to a television channel, are memorised before the sale of the receiver in a tuning memory (15) of the non volatile digital type, to a corresponding plurality of addresses and that for executing the direct call of the desired channel the user types on a command unit (16) the channel number, that said command unit (16) sends to a control unit (14) of the receiver a corresponding signal and that the control unit (14) reads in the memory (15) the corresponding digital code and sends it to the tuning unit (10) that provides for tuning the desired channel.

2. Tuning method for voltage synthesis television signal receivers, according to claim 1, characterised in that it provides an automatic tuning circuit (12) and means for modifying the respective digital code, in the presence of frequency drifting phenomonens, exceeding the pull-in range of such automatic tuning circuit (12), and that the television station is searched modifying the digital tuning code and contemporaneously verifying the presence of a station identification signal; and that the exact tuning is obtained verifying a signal (AFC) of an elevated slope coming from the automatic tuning circuit (12).

3. Tuning method for voltage synthesis television signal receivers, according to claim 2, characterised in that the search takes place at different and decreasing speeds depending on the combination of signals received by the identification circuit and by the automatic tuning circuit; a first speed when the identification signal is absent (zone A); a second speed lower than the first when the identification signal is present and the signal of the automatic tuning circuit is not to be found in the declining section (zone B-C); a third speed lower than the second when the signal of the automatic tuning circuit is to be found in the declining section (zone C-D).

4. Tuning method for voltage synthesis television signal receivers, according to claim 3, characterised in that, in the tuning phase of a station previously memorised, if not detected, with the previously memorised code, the presence of a station, said code is decreased using said first speed, for a prefixed maximum number (4) of times.

5. Tuning method for voltage synthesis television signal receivers, according to claim 4, characterised in that if, after one or more of said decreases, the presence of a station is detected, the search speed is reduced to said second value; and that successively, as soon as the declining section (C-D) of the curve of the automatic tuning (AFC) is detected, the speed of said third value is commutated, for the tuning search.

6. Tuning method for voltage synthesis television signal receivers, according to claim 4, characterised in that if, after one or more of said decreases, the presence of a station is detected, the search speed is reduced to said second value; and that successively, as soon as the declining section (C-D) of the curve of the automatic tuning (AFC) is detected, the speed of said third value is commutated, and finally, when the voltage coming from the automatic tuning corresponding to half of the maximum value is detected, the procedure is interrupted.

7. Tuning method for voltage synthesis television signal receivers, according to claim 4, characterised in that during the normal functioning of the receiver, the identification signal is controlled; if the presence of a station is not detected, no correction is executed; in the presence of a station, the signal coming from the automatic tuning circuit (AFC) is controlled; if a mistuning is detected, negative or positive, the provision is made for modifying the tuning code in consequence, utilising the third speed, for obtaining a variation in the opposite sense of the detected mistuning.

8. Tuning method for voltage synthesis television signal receivers, according to claim 1, characterised in that an auxiliary command unit (17) is provided, that can be contained in the signal receiver or can be available as a separate unit for sending to the control unit (14) the signals necessary for executing the preliminary tuning search of all the receivable channels, and the relative memorisation of the corresponding digital codes in the tuning memory (15).

9. Tuning method for voltage synthesis television signal receivers, according to claim 1, characterised in that a second non volatile memory (18) is provided, utilising for the memorisation of the preferred channels, that contain a plurality of cells, memorised in each of which, by way of the control unit (14), in following a command generated by the user, by way of the command unit (16), the correspondence between the number of a channel and the number of a key of the command unit (16) with which said channel can be called.

10. Television signals receiver that uses the method according to one or more of the previous claims.
